# EUROPÄISCHE PATENTSCHRIFT

(11) **EP 1 474 828 B1**
(45) Veröffentlichungstag und Bekanntmachung des Hinweises auf die Patenterteilung: **25.05.2005**
(21) Anmeldenummer: 03701416.4
(22) Anmeldetag: 13.02.2003
(51) Int. Cl.: H01L 23/04, H05K 5/06, H05K 7/14

(54) **GEHÄUSE FÜR EIN HOCHSPANNUNGSFESTES LEISTUNGSHALBLEITERMODUL**
HOUSING FOR A POWER SEMICONDUCTOR MODULE WHICH IS RESISTANT TO HIGH VOLTAGES
BOITIER POUR UN MODULE SEMI-CONDUCTEUR DE PUISSANCE RESISTANT AUX HAUTES TENSIONS

(30) Priorität: 14.02.2002 EP 02405110
(43) Veröffentlichungstag der Anmeldung: 10.11.2004
(73) Patentinhaber: ABB RESEARCH LTD., 8050 Zürich (CH)
(72) Erfinder: MEYSENC, Luc, CH-5405 Baden-Dättwil (CH); HAMIDI, Amina, CH-5400 Baden (CH); JOERG, Pieder, CH-7013 Domat/Ems (CH); AKDAG, Alper, CH-5406 Baden-Rütihof (CH)
(74) Vertreter: ABB Patent Attorneys
(86) Internationale Anmeldenummer: PCT/CH2003/000103
(87) Internationale Veröffentlichungsnummer: WO 2003/069968

(56) Entgegenhaltungen:
- EP-A- 0 251 260
- DE-A- 4 418 426
- PATENT ABSTRACTS OF JAPAN vol. 007, no. 222 (E-201), 4. Oktober 1983 (1983-10-04) & JP 58 112354 A (FUJI DENKI SEIZO KK), 4. Juli 1983 (1983-07-04)
- PATENT ABSTRACTS OF JAPAN vol. 1999, no. 08, 30. Juni 1999 (1999-06-30) & JP 11 067977 A (HITACHI LTD), 9. März 1999 (1999-03-09)

## Beschreibung

### Technisches Gebiet

Die Erfindung bezieht sich auf das Gebiet der Leistungselektronik. Sie betrifft ein Leistungshalbleitermodul nach dem Oberbegriff des unabhängigen Patentanspruchs.

### Stand der Technik

In der Leistungselektronik erfreuen sich intelligente und/oder applikationsspezifische Leistungshalbleitermodule (im Folgenden ASIPM genannt) einer zunehmenden Beliebtheit. In einem ASIPM sind ein oder mehrere Leistungshalbleiterbauelemente, welche eine Schaltfunktion übernehmen, mit einer Kontrolleinheit in einem Modul integriert und im Allgemeinen in einem gemeinsamen Gehäuse untergebracht. Bei den Leistungshalbleiterbauelementen handelt es sich beispielsweise um IGBTs mit parallelgeschalteter Diode. Die Kontrolleinheit kann beispielsweise neben einer eigentlichen Ansteuerung der Leistungshalbleiterbauelemente Schutzfunktionen zur Verfügung stellen, die zum Beispiel auf einer Temperatur- oder Stromüberwachung basieren und bei einem Überschreiten vorgegebener Grenzwerte die IGBTs abschalten.

Um bei einer Herstellung von ASIPMs eine Kompatibilität mit Herstellungsprozessen für Standardleistungshalbleitermodule zu ermöglichen, werden ASIPMs nach ähnlichen Richtlinien entworfen wie Standardleistungshalbleitermodule. Ein wesentlicher Unterschied besteht darin, dass beim ASIPM die Kontrolleinheit, welche im Allgemeinen auf einer Platine aufgebracht ist, ebenfalls im Gehäuse untergebracht werden muss. Während dies für niedrige Schaltspannungen bis etwa 1200V keine besonderen Schwierigkeiten mit sich bringt, resultieren bei steigenden Schaltspannungen spezielle Anforderungen aus einer notwendigen elektrischen Isolation zwischen der Kontrolleinheit und den Leistungshalbleiterbauelementen und zwischen entsprechenden Zuleitungen.

Um eine elektrische Isolation zu gewährleisten, wird das Innere das Gehäuses häufig mit Isolationsmaterial gefüllt. Zu diesem Zweck wird bevorzugt ein Silikongel verwendet, welches in flüssiger Form in das Gehäuse gegossen und bei Bedarf mehr oder weniger stark ausgehärtet werden kann. Das Isolationsmaterial kann somit in Form einer mehr oder weniger viskosen Flüssigkeit oder auch in fester Form vorliegen. Dabei wird im Allgemeinen das Gehäuse nicht vollständig mit dem Isolationsmaterial gefüllt, da dies bei einer thermischen Volumenausdehnung des Isolationsmaterials infolge Erwärmung bei einem Betrieb des ASIPM zu einer - im ungünstigsten Fall, insbesondere bei einem Kurzschluss, explosionsartigen - Zerstörung des Gehäuses führen würde. Vorzugsweise wird die Menge an Isolationsmaterial so bemessen, dass ein gasgefülltes Volumen im Inneren des Gehäuses frei von Isolationsmaterial bleibt.

Bei entsprechend hohen Schaltspannungen, insbesondere bei den typischen Mittelspannungsklassen 2.3kV, 3.3kV, 4.16kV und 6.9kV, bleibt dennoch ein Problem bestehen, da sich bei nicht isolierten Zuleitungen, welche durch das gasgefüllte Volumen geführt sind, an einer an das gasgefüllte Volumen des Isolationsmaterials grenzenden Oberfläche Kriechströme ausbilden können, welche zu Kurzschlüssen im ASIPM führen. Bei zu geringen Abständen zwischen den Zuleitungen können zudem Durchschläge im gasgefüllten Volumen auftreten. Kriechströme wie Durchschläge können zu einer Beschädigung oder Zerstörung des ASIPM, aber auch eines übergeordneten Systems, in welches das ASIPM integriert ist, führen, und sind deswegen unerwünscht.

JP-A-58 112 354 (FUJI DENKI SEIZO KK) offenbart ein Leistungshalbleitermodul des bisherigen Stands der Technik.

### Beschreibung der Erfindung

Es ist Aufgabe der Erfindung, ein Leistungshalbleitermodul der eingangs genannten Art anzugeben, bei welchem Kriechströme und Durchschläge in einem Inneren eines Gehäuses zwischen einer ersten und einer zweiten Zuleitung unterdrückt werden.

Ein Leistungshalbleitermodul mit den Merkmalen des unabhängigen Patentanspruches löst diese Aufgabe. Weitere vorteilhafte Ausgestaltungen der Erfindung sind in den unabhängigen Ansprüchen angegeben.

Erfindungsgemäss ist ein Mittel zur Unterdrückung von Kriechströmen vorgesehen, welches in einem Bereich zwischen den beiden Zuleitungen in eine Oberfläche eines Isolationsmaterials eingesenkt ist, d.h. dass das Mittel im Falle eines flüssigen Isolationsmaterials in das Isolationsmaterial eintaucht, im Falle eines festen Isolationsmaterials in eine Vertiefung in der Oberfläche hineingreift, wobei die Vertiefung vorzugsweise dadurch entsteht, dass ein zunächst flüssiges Isolationsmaterial, in welches das Mittel eintaucht, ausgehärtet wird.

In einer bevorzugten Weiterbildung der Erfindung weist eine Gehäusewand eine elektrisch isolierende Ausformung auf, welche in einem Bereich zwischen den beiden Zuleitungen in eine Oberfläche eines Isolationsmaterials eingesenkt ist.

In einer vorteilhaften Weiterbildung der Erfindung ist die Ausformung so geformt, dass sie in einem gasgefüllten Volumen im Inneren des Gehäuses die erste und die zweite Zuleitung voneinander abschirmt.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit den Zeichnungen offensichtlich.

### Kurze Erläuterung der Zeichnungen

Es zeigen schematisch:

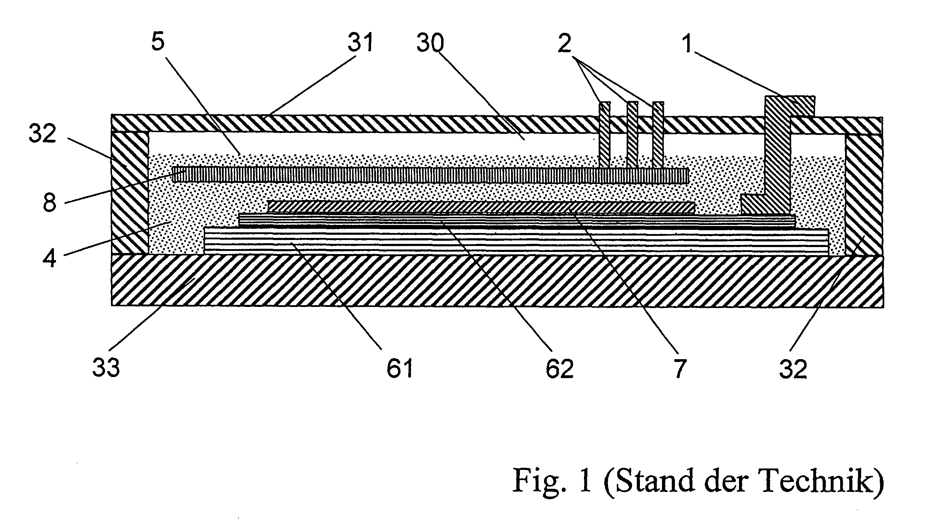

Fig. 1 ein Leistungshalbleitermodul gemäss dem Stand der Technik,
Fig. 2 ein erfindungsgemässes Leistungshalbleitermodul,
Fig. 3 beispielhafte Querschnitte durch das Leistungshalbleitermodul aus Fig. 2 entlang der Linie A-B,
Fig. 4 eine vorteilhafte Weiterbildung eines erfindungsgemässen Leistungshalbleitermoduls,
Fig. 5 eine alternative Ausgestaltung eines erfindungsgemässen Leistungshalbleitermoduls,
Fig. 6 weitere beispielhafte Querschnitte durch eine vorteilhafte Weiterbildungen eines erfindungsgemässen Leistungshalbleitermoduls gemäss Fig. 2 (Fig. 6 a), b) und c)) bzw. gemäss Fig. 5 (Fig. 6 b)) entlang der Linie A-B.

Die in den Zeichnungen verwendeten Bezugszeichen und deren Bedeutung sind in der Bezugszeichenliste zusammengefasst. Grundsätzlich sind gleiche Teile mit gleichen Bezugszeichen versehen.

### Wege zur Ausführung der Erfindung

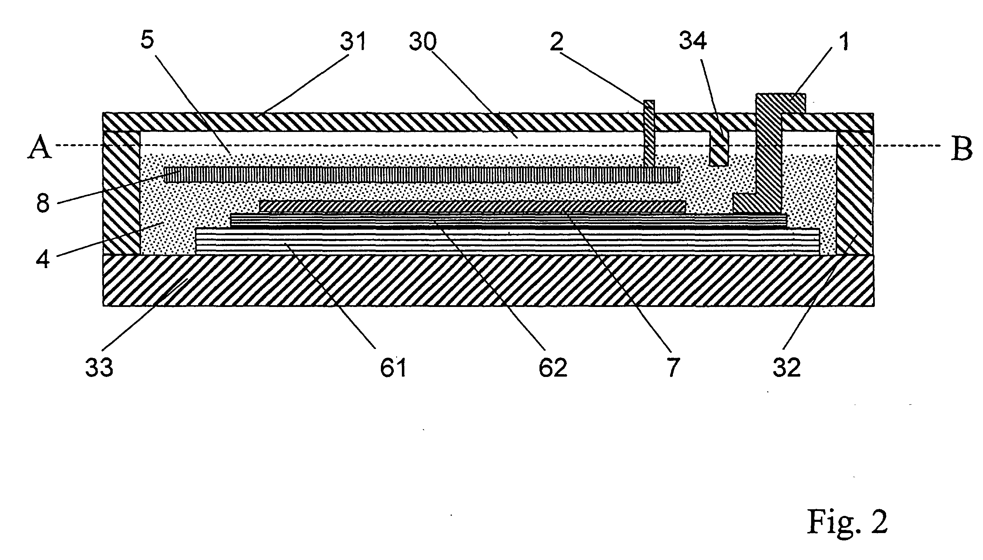

Fig. 2 zeigt schematisch ein erfindungsgemässes Leistungshalbleitermodul. In einem Inneren eines Gehäuses, welches von Gehäusewänden, d.h. einem Gehäuseboden 33, Gehäuseseiten 32 und einer Gehäuseabdeckung 31 gebildet wird, welche aus elektrisch isolierendem Material bestehen, ist ein Leistungshalbleiterbauelement 7 mit mindestens einem ersten und einem zweiten Hauptkontakt mittels einer elektrisch leitenden Schicht 62 auf einem Substrat 61 aufgebracht. Eine Kontrolleinheit 8, welche einen elektronischen Schaltkreis aufweist, der auf einer Platine aufgebaut ist und mittels welcher das Leistungshalbleiterbauelement 7 ansteuerbar ist, befindet sich ebenfalls im Inneren des Gehäuses. Ein erster Teil des Gehäuses ist mit einem Isolationsmaterial 4 gefüllt, so dass sowohl das Leistungshalbleiterbauelement 7 als auch die Kontrolleinheit 8 vom Isolationsmaterial 4 eingeschlossen sind. Ein verbleibender zweiter Teil des Gehäuses, in welchem sich kein Isolationsmaterial 4 befindet, bildet ein gasgefülltes Volumen 30, so dass eine Oberfläche 5 des Isolationsmaterials 4 an dieses gasgefüllte Volumen 30 grenzt. Das gasgefüllte Volumen 30 enthält vorzugsweise Luft, es kann jedoch vorteilhaft auch mit einem Isolationsgas gefüllt sein.

Eine erste elektrische Zuleitung 1 kontaktiert die elektrisch leitende Schicht 62, eine zweite elektrische Zuleitung 2 die Kontrolleinheit 8. Die erste elektrische Zuleitung 1 und die zweite elektrische Zuleitung 2 sind beide durch das gasgefüllte Volumen 30 und die Oberfläche 5 in das Isolationsmaterial 4 geführt. Die Gehäuseabdeckung 31 weist eine Ausformung 34 auf, welche in einem Bereich zwischen der ersten elektrischen Zuleitung 1 und der zweiten elektrischen Zuleitung 2 in die Oberfläche eingesenkt ist.

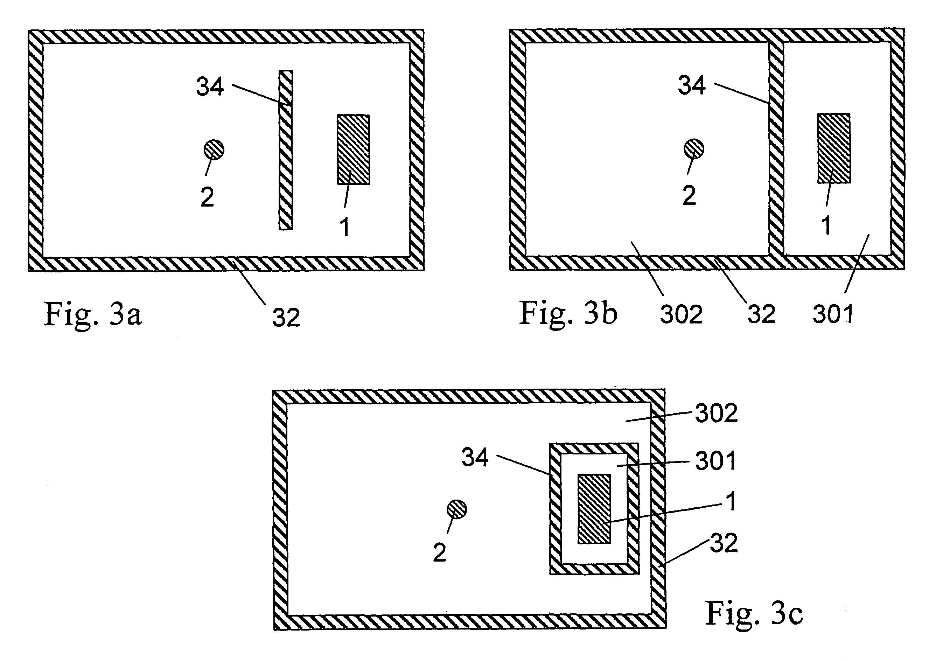

Fig. 3a zeigt einen Schnitt durch das Leistungshalbleitermodul aus Fig. 2 entlang der Linie A-B. Daraus ist ersichtlich, dass eine Kriechstrecke, d.h. die kürzeste Entfernung zwischen der ersten elektrischen Zuleitung 1 und der zweiten elektrischen Zuleitung 2 auf der Oberfläche 5 durch die Ausformung 34 im Vergleich zu einem Leistungshalbleitermodul aus dem Stand der Technik, bei dem die Ausformung 34 nicht vorhanden ist, deutlich verlängert wird. In einer bevorzugten Ausgestaltung der Erfindung, wie sie in Fig. 3b im Schnitt gezeigt ist, unterteilt die Ausformung 34 der Gehäuseabdeckung 31 das gasgefüllte Volumen 30 ein Teilvolumen 301, durch welches die erste elektrische Zuleitung 1 geführt ist, und in ein Restvolumen 302, durch welches der zweite elektrische Zuleitung 2 geführt ist. Somit ist keine Kriechstrecke zwischen der ersten elektrischen Zuleitung 1 und der zweiten elektrischen Zuleitung 2 mehr auf der Oberfläche 5 vorhanden, die Kriechstrecke wird also durch die Ausformung 34 der Gehäuseabdeckung 31 eliminiert. In einer weiteren bevorzugten Ausgestaltung der Erfindung, die in Fig. 3c im Schnitt gezeigt ist, wird das gasgefüllte Volumen 30 in gleicher Weise von der Ausformung 34 unterteilt, womit ebenfalls keine Kriechstrecke auf der Oberfläche 5 vorhanden ist.

Als Isolationsmaterial 4 wird vorzugsweise ein Gel verwendet, vorzugsweise ein Silikongel oder Polyurethan. In Frage kommen beispielsweise Elektronik-Vergussmassen aus Silikon von Dow Corning (Sylguard 527), Wacker (Silgel), Toshiba u.a.m. Diese Massen werden z.T. aus zwei Komponenten angemischt oder sind einkomponentig. Ein derartiges Isolationsmaterial 4 kann vorteilhaft in flüssiger Form in das Gehäuse eingebracht, vorzugsweise eingegossen, werden. Je nach Anwendung und Viskosität des Isolationsmaterials 4 kann dieses in flüssiger Form belassen werden, wozu sich beispielsweise Silikongel eignet. In diesem Fall taucht die Ausformung 34 in das Isolationsmaterial ein und ist auf diese Weise in die Oberfläche 5 eingesenkt. Für bestimmte Anwendungen andererseits kann es notwendig sein, das Isolationsmaterial 4 auszuhärten, was sowohl durch Erwärmung als auch durch Zuwarten erfolgen kann. Bei einer Aushärtung, die sich vorteilhaft bei Epoxyd erreichen lässt, bildet sich durch die eingetauchte Ausformung 34 in der Oberfläche 5 eine entsprechend geformte Vertiefung, in welche die Ausformung 34 nach der Aushärtung eingesenkt ist. Vorteilhaft können auch Öle als Isolationsmaterial 4 eingesetzt werden. Diese sind aufgrund ihrer Flüssigkeitseigenschaft selbstheilend, d.h. nach einem Durchschlag bleibt kein dauerhafter Defekt im Isolationsmaterial 4 bestehen.

Wie aus den Fig. 2 und 3 ersichtlich ist, weist die Ausformung 34 vorzugsweise eine solche Form auf, dass sie die erste elektrische Zuleitung 1 und die zweite elektrische Zuleitung 2 im gasgefüllten Volumen 30 gegeneinander abschirmt. Auf diese Weise werden nicht nur Kriechströme auf der Oberfläche 5 unterbunden, sondern auch Durchschläge durch das gasgefüllte Volumen 30 verhindert.

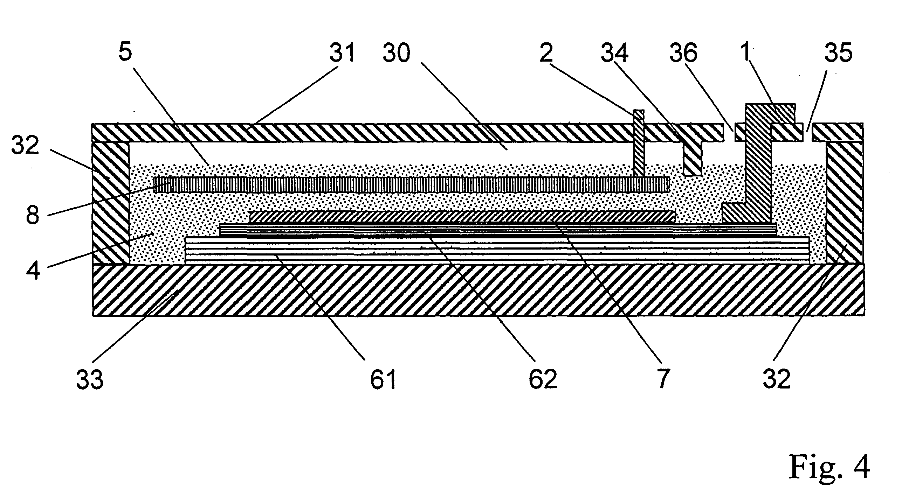

Fig. 4 zeigt eine vorteilhafte Weiterbildung eines erfindungsgemässen Leistungshalbleitermoduls nach Fig. 3b oder 3c. Dabei weist die Gehäuseabdeckung 341 eine erste Öffnung 35 und eine zweite Öffnung 36 auf, welche das Teilvolumen 301 mit einem Äusseren des Gehäuses verbinden. Dies erlaubt ein Nachfüllen einer Isolationsflüssigkeit in das Innere des Gehäuses. Dabei dient die erste Öffnung 35 zum Nachfüllen der Isolationsflüssigkeit, während die zweite Öffnung 36 ein Entweichen von Gas aus dem Teilvolumen 301 ermöglicht. Vorzugsweise geschieht das Nachfüllen von Isolationsflüssigkeit nach dem Aushärten des Isolationsmaterials 4. Da die Ausformung 34 in diesem Fall in die Oberfläche 5 eingesenkt ist, kann die nachgefüllte Isolationsflüssigkeit nicht aus dem Teilvolumen 301 entweichen, so dass das Restvolumen 302 mit Gas gefüllt bleibt.

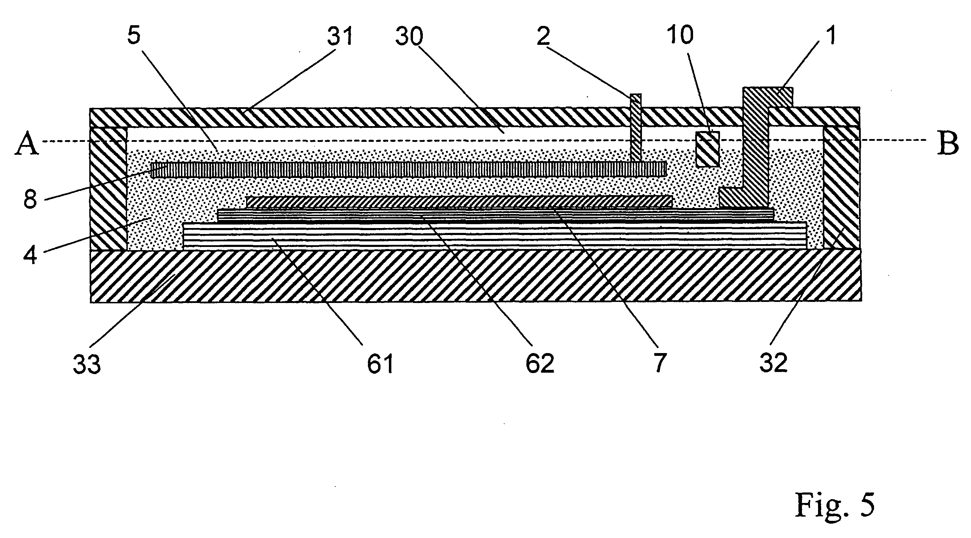

Fig. 5 zeigt eine alternative Ausgestaltung der Erfindung. Die Unterdrückung von Kriechströmen auf der Oberfläche 5 des Isolationsmaterials 4 wird in diesem Fall durch einen Isolationskörper 10 gebildet, welcher in die Oberfläche 5 eingesenkt ist. Im Falle eines flüssigen Isolationsmaterials 4 ist dabei eine mittlere Dichte des Isolationskörpers 10 geeignet zu wählen, so dass dieser auf der Oberfläche 5 schwimmt, dabei aber vorzugsweise partiell in das Isolationsmaterial 4 eintaucht. Besonders vorteilhaft ist in diesem Fall ein ringförmiger Isolationskörper 10, welcher die erste elektrische Zuleitung 1 oder die zweite elektrische Zuleitung 2 umgreift. Bei einem derartigen Isolationskörper 10 können Massnahmen zur Positionierung entfallen. Falls das Isolationsmaterial 4 ausgehärtet wird, muss der Isolationskörper 10 gegebenenfalls während der Aushärtung in einer entsprechenden Position gehalten werden.

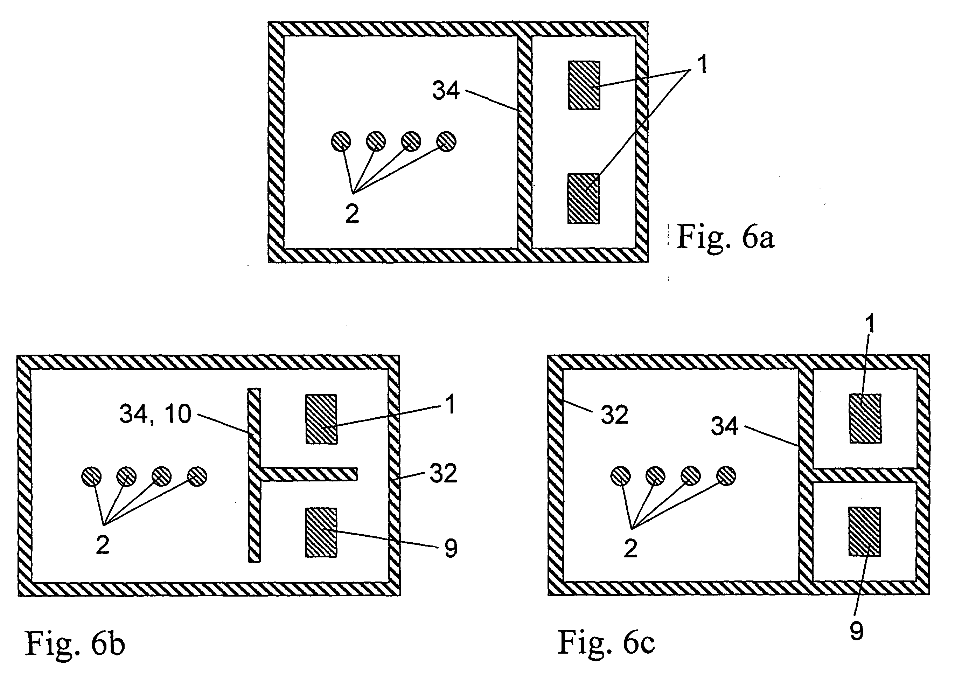

Fig. 6 zeigt weitere Querschnitte durch vorteilhafte Weiterbildungen eines erfindungsgemässen Leistungshalbleitermoduls. Fig. 6a zeigt ein mögliches Beispiel eines Leistungshalbleitermoduls, welches mehrere erste elektrische Zuleitungen 1 und mehrere zweite elektrische Zuleitungen 2 aufweist, wobei die Ausformung 34 der Gehäuseabdeckung 31 zwischen den ersten elektrischen Zuleitungen 1 und den zweiten elektrischen Zuleitungen 2 in die Oberfläche 5 des Isolationsmaterials 4 eingesenkt ist. Das Leistungshalbleitermodul in Fig. 6b und 6c weist neben der ersten elektrischen Zuleitung 1 und mehreren zweiten elektrischen Zuleitungen 2 eine dritte elektrische Zuleitung 9 auf. Der Isolationskörper 10 bzw. die Ausformung 34 der Gehäuseabdeckung 31 ist in diesem Fall so beschaffen, dass sie zwischen allen aus der ersten elektrischen Zuleitung 1, den zweiten elektrischen Zuleitungen 2 und der dritten elektrischen Zuleitung 9 gebildeten Paaren in die Oberfläche 5 eingesenkt ist.

Obwohl bisher nur in Verbindung mit einer zweiten elektrischen Zuleitung 2 zu einer Kontrolleinheit beschreiben, kann die Verbindung vorteilhaft auch in solchen Fällen angewendet werden, in denen die erste und zweite elektrische Zuleitung (1,2) den ersten bzw. zweiten Hauptkontakt des Leistungshalbleiterbauelements 7 kontaktieren. In diesem Fall kann eine Kontrolleinheit 8 vorhanden sein, dies ist aber keine Voraussetzung für die Anwendung der Erfindung. Ebenfalls können einzelne Gehäusewände, insbesondere der Gehäuseboden 33 elektrisch leitend ausgeführt sein, vorteilhaft um beispielsweise bei druckkontaktierten Leistungshalbleitermodulen eine Kontaktierung des Leistungshalbleiterbauelements 7 über eine solche Gehäusewand vorzunehmen. Dabei kann ein Isolationskörper 10 vorzugsweise an einer elektrisch leitenden Gehäusewand befestigt sein und somit eine eletrisch isolierende Ausformung 34 dieser Gehäusewand bilden.

### Bezugszeichenliste

- 1: Erste Zuleitung, erste Zuleitungen
- 2: Zweite Zuleitung, zweite Zuleitungen
- 30: Gasgefülltes Volumen
- 301: Teilvolumen
- 302: Restvolumen
- 31: Gehäuseabdeckung
- 32: Gehäuseseitenwand
- 33: Gehäuseboden
- 34: Elektrisch isolierende Ausformung
- 35: Erste Öffnung
- 36: Zweite Öffnung
- 4: Isolationsmaterial
- 5: Oberfläche
- 61: Substrat
- 62: Lotschicht
- 7: Leistungshalbleiterbauelement
- 8: Kontrolleinheit
- 9: Dritte Zuleitung
- 10: Isolationskörper

## Patentansprüche

1. Leistungshalbleitermodul, umfassend
- ein teilweise mit einem Isolationsmaterial (4) gefülltes Gehäuse,
- ein vom Isolationsmaterial (4) bedecktes Leistungshalbleiterbauelement (7),
- ein gasgefülltes Volumen (30) in einem Inneren des Gehäuses,
- eine an das gasgefüllte volumen (30) grenzende Oberfläche (5) des Isolationsmaterials,
- mindestens eine erste elektrische Zuleitung (1) und eine zweite elektrische Zuleitung (2), welche durch das gasgefüllte Volumen (30) und die Oberfläche (5) in das Isolationamaterial (4) geführt sind,
**dadurch gekennzeichnet, dass**
- ein Mittel (10) zur Verlängerung oder Eliminierung einer auf der Oberfläche (5) des Isolationsmaterials (4) verlaufenden Kriechstrecke in einem Bereich zwischen der ersten elektrischen Zuleitung (1) und der zweiten elektrischen Zuleitung (2) in diese Oberfläche (5) eingesenkt ist und das Mittel (10) ein Isolationskörper (10) ist.

2. Leistungahalbleitermodul, umfassend
- ein teilweise mit einem Isolationsmaterial (4) gefülltes Gehäuse,
- ein vom Isolationsmaterial (4) bedecktes Leistungshalbleiterbauelement (7),
- ein gasgefülltes Volumen (30) in einem Inneren des Gehäuses,
- eine an das gasgefüllte Volumen (30) grenzende Oberfläche (5) des Isolationsmaterials,
- mindestens eine erste elektrische Zuleitung (1) und eine zweite elektrische Zuleitung (2), welche durch das gasgefüllte Volumen (30) und die Oberfläche (5) in das Isolationsmaterial (4) geführt sind,
- ein Mittel (34) zur Verlängerung oder Eliminierung einer auf der Oberfläche (5) des Isolationsmaterials (4) verlaufenden Kriechstrecke in einem Bereich zwischen der ersten elektrischen Zuleitung (1) und der zweiten elektrischen Zuleitung (2) in diese Oberfläche (5) eingesenkt ist und das Mittel (34) eine elektrisch isolierende Ausformung (34) einer Gehäusewand (31, 32, 33) ist,
**dadurch gekennzeichnet, dass**
- die Ausformung (34) die erste elektrische Zuleitung (1) und die zweite elektrische Zuleitung (2) im gasgefüllten Volumen (30) gegeneinander abschirmt.

3. Leistungshalbleitermodul nach Anspruch 1 oder 2,
**dadurch gekennzeichnet, dass**
- das Leistungshalbleitermodul mindestens eine Kontrolleinheit (8) enthält, mittels welcher das Leistungshalbleiterbauelement (7) ansteuerbar ist.

4. Leistungshalbleitermodul nach Anspruch 3, **dadurch gekennzeichnet, dass**
- die Kontrolleinheit (8) vom Isolationsmaterial (4) umgeben ist.

5. Leistungshalbleitermodul nach Anspruch 3 oder 4, **dadurch gekennzeichnet, dass**
- das Leistungshalbleiterbauelement mindestens einen Hauptkontakt aufweist,
- die erste elektrische Zuleitung (1) den mindestens einen Hauptkontakt des Leistungshalbleiterbauelements (7) kontaktiert und dass
- die zweite elektrische Zuleitung (2) die Kontrolleinheit (8) kontaktiert.

6. Leistungshalbleitermodul nach Anspruch 2, **dadurch gekennzeichnet, dass**
- die Ausformung (34) der Gehäusewand (31, 32, 33) ein Teilvolumen (301) des gasgefüllten Volumens (30), durch welches Teilvolumen (301) die erste elektrische Zuleitung (1) geführt ist, von einem Restvolumen (302), durch welches die zweite elektrische Zuleitung (2) geführt ist, abtrennt.

7. Leistungshalbleitermodul nach Anspruch 6, **dadurch gekennzeichnet, dass**
- die Gehäusewand (31, 32, 33) eine erste und eine zweite Öffnung (35,35) aufweist, welche das Teilvolumen (301) mit einem Äueseren des Gehäuses verbinden.

8. Leistungshalbleitermodul nach Anspruch 7, **dadurch gekennzeichnet, dass**
- die Ausformung der Gehäusewand (34) die erste oder zweite elektrische Zuleitung (1,2) röhrenförmig umschliesst.

## Claims

1. Power semiconductor module, comprising
- a housing partially filled with an insulation material (4),
- a power semiconductor component (7) covered by the insulation material (4),
- a gas-filled volume (30) in an interior of the housing,
- a surface (5) of the insulation material that adjoins the gas-filled volume (30),
- at least a first electrical lead (1) and a second electrical lead (2), which are led through the gas-filled volume (30) and the surface (5) into the insulation material (4),
**characterized in that**
- a means (10) for lengthening or eliminating a creepage path running on the surface (5) of the insulation material (4), in a region between the first electrical lead (1) and the second electrical lead (2), is sunk into said surface (5) and the means (10) is an insulation body (10).

2. Power semiconductor module, comprising
- a housing partially filled with an insulation material (4),
- a power semiconductor component (7) covered by the insulation material (4),
- a gas-filled volume (30) in an interior of the housing,
- a surface (5) of the insulation material that adjoins the gas-filled volume (30),
- at least a first electrical lead (1) and a second electrical lead (2), which are led through the gas-filled volume (30) and the surface (5) into the insulation material (4),
- a means (34) for lengthening or eliminating a creepage path running on the surface (5) of the insulation material (4), in a region between the first electrical lead (1) and the second electrical lead (2), is sunk into said surface (5) and the means (34) is an electrically insulating shaped portion (34) of a housing wall (31, 32, 33),
**characterized in that**
- the shaped portion (34) screens the first electrical lead (1) and the second electrical lead (2) from one another in the gas-filled volume (30).

3. Power semiconductor module according to Claim 1 or 2, **characterized in that**
- the power semiconductor module contains at least one control unit (8), by means of which the power semiconductor component (7) can be driven.

4. Power semiconductor module according to Claim 3, **characterized in that**
- the control unit (8) is surrounded by the insulation material (4).

5. Power semiconductor module according to Claim 3 or 4, **characterized in that**
- the power semiconductor component has at least one main contact,
- the first electrical lead (1) makes contact with the at least one main contact of the power semiconductor component (7), and **in that**
- the second electrical lead (2) makes contact with the control unit (8).

6. Power semiconductor module according to Claim 2, **characterized in that**
- the shaped portion (34) of the housing wall (31, 32, 33) separates a partial volume (301) of the gas-filled volume (30), through which partial volume (301) the first electrical lead (1) is led, from a remaining volume (302), through which the second electrical lead (2) is led.

7. Power semiconductor module according to Claim 6, **characterized in that**
- the housing wall (31, 32, 33) has a first and a second opening (35, 35), which connect the partial volume (301) to an exterior of the housing.

8. Power semiconductor module according to Claim 7, **characterized in that**
- the shaped portion of the housing (34) encloses the first or second electrical lead (1, 2) in tubular fashion.

## Revendications

1. Module semiconducteur de puissance, comprenant
- un boîtier partiellement rempli d'un matériau isolant (4),
- un composant semiconducteur de puissance (7) recouvert par le matériau isolant (4),
- un volume rempli de gaz (30) dans un espace intérieur du boîtier,
- une surface (5) du matériau isolant qui délimite le volume rempli de gaz (30),
- au moins une première ligne électrique d'arrivée (1) et une deuxième ligne électrique d'arrivée (2) qui sont acheminées dans le matériau isolant (4) à travers le volume rempli de gaz (30) et la surface (5),
**caractérisé en ce que**
- un moyen (10) de prolongation ou d'élimination d'une ligne de fuite qui s'étend sur la surface (5) du matériau isolant (4) dans une zone entre la première ligne électrique d'arrivée (1) et la deuxième ligne électrique d'arrivée (2) est encastré dans cette surface (5) et le moyen (10) est un corps isolant (10).

2. Module semiconducteur de puissance, comprenant
- un boîtier partiellement rempli d'un matériau isolant (4),
- un composant semiconducteur de puissance (7) recouvert par le matériau isolant (4),
- un volume rempli de gaz (30) dans un espace intérieur du boîtier,
- une surface (5) du matériau isolant qui délimite le volume rempli de gaz (30),
- au moins une première ligne électrique d'arrivée (1) et une deuxième ligne électrique d'arrivée (2) qui sont acheminées dans le matériau isolant (4) à travers le volume rempli de gaz (30) et la surface (5),
- un moyen (34) de prolongation ou d'élimination d'une ligne de fuite qui s'étend sur la surface (5) du matériau isolant (4) dans une zone entre la première ligne électrique d'arrivée (1) et la deuxième ligne électrique d'arrivée (2) qui est encastré dans cette surface (5) et le moyen (34) est une déformation (34) électriquement isolante d'une paroi du boîtier (31, 32, 33),
**caractérisé en ce que**
- la déformation (34) fait écran entre la première ligne électrique d'arrivée (1) et la deuxième ligne électrique d'arrivée (2) dans le volume (30) rempli de gaz.

3. Module semiconducteur de puissance selon la revendication 1 ou 2, **caractérisé en ce que** le module semiconducteur de puissance comprend au moins une unité de contrôle (8) à l'aide de laquelle le composant semiconducteur de puissance (7) peut être commandé.

4. Module semiconducteur de puissance selon la revendication 3, **caractérisé en ce que** l'unité de contrôle (8) est entourée par le matériau isolant (4).

5. Module semiconducteur de puissance selon la revendication 3 ou 4, **caractérisé en ce que**
- le composant semiconducteur de puissance présente au moins un contact principal,
- la première ligne électrique d'arrivée (1) est en contact avec l'au moins un contact principal du composant semiconducteur de puissance (7) et que
- la deuxième ligne électrique d'arrivée (2) est en contact avec l'unité de contrôle (8).

6. Module semiconducteur de puissance selon la revendication 2, **caractérisé en ce que** la déformation (34) de la paroi du boîtier (31, 32, 33) sépare un volume partiel (301) du volume rempli de gaz (30), volume partiel (301) à travers lequel passe la première ligne électrique d'arrivée (1), d'un volume restant (302) à travers lequel passe la deuxième ligne électrique d'arrivée (2).

7. Module semiconducteur de puissance selon la revendication 6, **caractérisé en ce que** la paroi du boîtier (31, 32, 33) présente une première et une deuxième ouverture (35, 35) qui relient le volume partiel (301) avec un espace extérieur du boîtier.

8. Module semiconducteur de puissance selon la revendication 7, **caractérisé en ce que** la déformation de la paroi du boîtier (34) entoure en forme de tube la première ou la deuxième ligne électrique d'arrivée (1, 2) .
